# EUROPEAN PATENT SPECIFICATION

(11) **EP 1 766 696 B1**
(45) Date of publication and mention of the grant of the patent: **05.03.2014**
(21) Application number: 05758109.2
(22) Date of filing: 04.07.2005
(51) Int. Cl.: H01L 33/00

(54) **LIGHT-EMITTING DEVICE**
LICHTEMITTIERENDE VORRICHTUNG
DISPOSITIF ÉLECTROLUMINESCENT

(30) Priority: 09.07.2004 JP 2004203486; 24.02.2005 JP 2005049321
(43) Date of publication of application: 28.03.2007
(73) Proprietor: Panasonic Corporation, Kadoma-shi Osaka 571-8501 (JP)
(72) Inventor: OGATA, Toshifumi Matsushita El. Ind. Co., Ltd.,, Osaka-shi, Osaka 540-6319 (JP); TANIMOTO, Noriyasu Matsushita El. Ind. Co., Ltd., Osaka-shi, Osaka 540-6319 (JP); NAGAI, Hideo Matsushita El. Ind. Co., Ltd., Osaka-shi, Osaka 540-6319 (JP); TAKAHASHI, Kiyoshi Matsushita El. Ind. Co., Ltd., Osaka-shi, Osaka 540-6319 (JP)
(74) Representative: Eisenführ Speiser
(86) International application number: PCT/JP2005/012716
(87) International publication number: WO 2006/006544

(56) References cited:
- EP-A- 1 249 874
- WO-A-03/001612
- DE-A1- 10 214 119
- DE-A1- 10 261 428
- US-A- 3 875 456
- US-A- 4 032 963
- US-A- 4 774 434
- US-A1- 2001 042 865
- US-A1- 2002 084 749
- US-B1- 6 219 074
- US-B1- 6 734 465
- YOKOYAMA, M & KINJO, N: "Electric Conductivity of Silicone Elastomers Vulcanized by the Hydrosilation Reaction" JOURNAL OF APPLIED POLYMER SCIENCE, vol. 29, no. 8, August 1984 (1984-08), pages 2665-2670, XP002351120

## Description

### Technical Field

The present invention relates to a light-emitting device such as a light-emitting diode, using a light-emitting element.

### Background Art

Light-emitting diodes (in the following, referred to as "LEDs") are superior in luminous efficiency, lifetime etc. over incandescent lamps, halogen lamps or the like. Thus, they have come into use as a light-emitting device in various displays and luminaires. The LED basically includes a light-emitting element and a sealing portion that seals this light-emitting element.

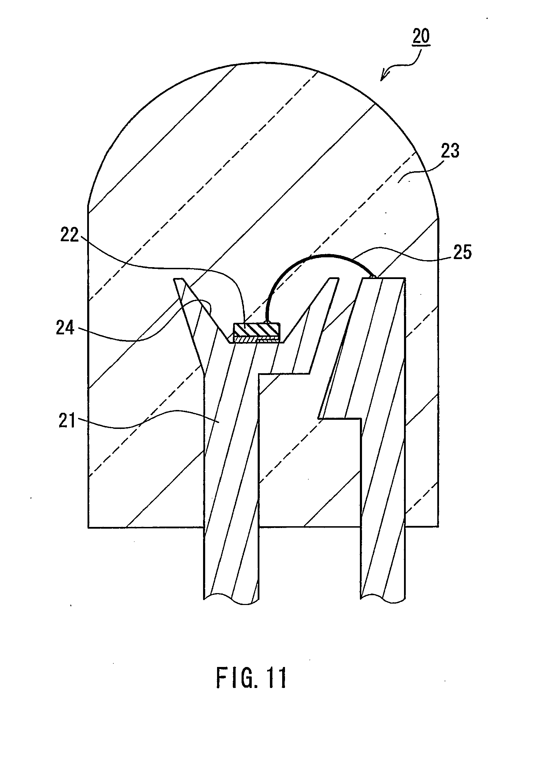

FIG. 11 is a sectional view showing a conventional lamp-type LED. A conventional lamp-type LED 20 has a structure in which a light-emitting element 22 mounted on a lead frame 21 is sealed with a single light-transmitting sealing resin 23 such as an epoxy resin. Further, the lamp-type LED 20 includes a reflecting plate 24 for reflecting light emitted from the light-emitting element 22 in a given direction and a wire 25 for supplying electricity to the light-emitting element 22. Moreover, the sealing resin 23 sometimes is mixed with a phosphor for converting an emission wavelength of the light-emitting element 22 into another wavelength or with a filter material, a pigment or the like for absorbing a specific wavelength (see JP 2001-57447 A, for example).

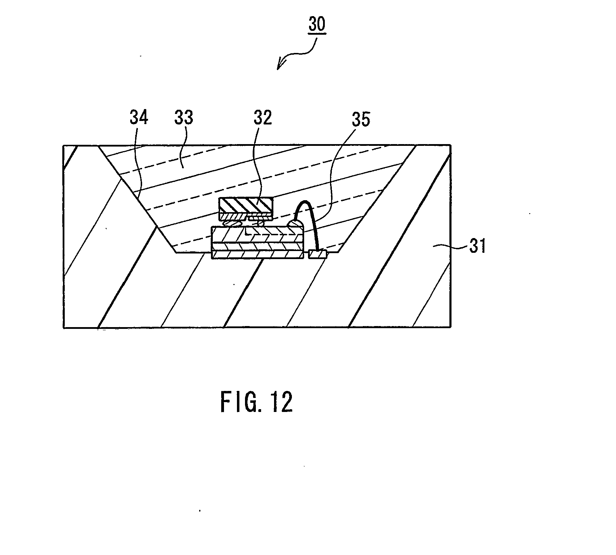

Further, FIG. 12 is a sectional view showing a conventional surface mount-type LED. A conventional surface mount-type LED 30 has a structure in which a light-emitting element 32 mounted in a cup 31 is sealed with a single light-transmitting sealing resin 33 such as a silicone resin or an epoxy resin. Further, the surface mount-type LED 30 includes a reflecting plate 34 for reflecting light emitted from the light-emitting element 32 in a given direction and a wire 35 for supplying electricity to the light-emitting element 32. Moreover, the sealing resin 33 sometimes is mixed with a phosphor for converting an emission wavelength of the light-emitting element 32 into another wavelength or with a filter material, a pigment or the like for absorbing a specific wavelength.

As a material for sealing the light-emitting element, various materials having a high light transmittance such as an epoxy resin, a silicone resin and a urea resin conventionally have been used. Considering reliability, costs and the like, the epoxy resin is used mainly.

The epoxy resin has a high adhesiveness to the lead frame and the substrate on which the light-emitting element is mounted and a high hardness, which makes it easy to protect the light-emitting element against an external shock. On the other hand, the epoxy resin has a property of relatively easy degradation from heat and light. Although there are various epoxy resins that are resistant to heat and light, their light-transmitting properties are easily degraded over time because they are influenced directly by both light and heat as long as they are in direct contact with the light-emitting element. In particular, since these resins absorb light on a short wavelength side, they turn into a yellowish color, so that a light extraction efficiency lowers. Such a degradation of epoxy resins lowers a luminous flux of the LED, leading to a shorter lifetime of the LED.

When luminaires using an LED come into use in the future, a large number of LEDs have to be mounted to obtain a desired luminous flux because a single LED has only a small luminous flux. Accordingly, it is desired that the reliability of each LED be improved. Also, when a light-emitting element that emits light in blue and ultraviolet regions begins to be used as a light-emitting element to be combined with a phosphor for a use in an LED emitting white light (in the following, referred to as a "white LED"), the sealing material needs to have a further resistance to light and heat. If the light-emitting device using the LED as an illuminating light source is sealed with a single resin, namely, an epoxy resin alone, the lifetime thereof is likely to become extremely short.

On the other hand, compared with the epoxy resin, a silicone material has a property of being relatively stable toward heat and light. The light-transmitting property of the silicone material does not degrade easily over time, so that the silicone material does not turn into a yellowish color easily.

However, the silicone material is unlikely to have a rigidity as high as the epoxy resin. Even if it has a hardness equivalent to the epoxy resin, it is more difficult to mold than the epoxy resin, so that the mechanical protection of the light-emitting element cannot be provided easily. Furthermore, compared with the epoxy resin, the silicone material has a poor adhesiveness to the lead frame and the substrate on which the light-emitting element is mounted. Therefore, phenomena such as thermal shock and the like accompanied by expansion and shrinkage of each member easily bring about deficiencies such as peeling. Accordingly, it is difficult to maintain the sealing for a long time, and the reliability in the sealing portion is lower compared with the sealing with the epoxy resin.

The LED needs to have a sufficient rigidity in its outer part of the sealing portion and has to be sealed with a sealing material having a large mechanical strength in order to protect the light-emitting element from an external shock. On the other hand, in a part contacting the light-emitting element, for the purpose of preventing damages caused by an application of a mechanical stress to the light-emitting element or cracks generated in the sealing material in the vicinity of the light-emitting element, the sealing has to be carried out with a sealing material having a certain elasticity.

However, as described above, it is difficult to meet these requirements simultaneously with a single sealing material, for example, an epoxy resin or a silicone material. Thus, a sealing portion with a double layer structure conventionally has been suggested in which the vicinity of the light-emitting element is covered with an elastic silicone material and its outer side is covered with a resin or the like having a large mechanical strength (for example, see FIG. 2 of JP 2000-150968 A).

However, even an LED with the double layer structure in which the vicinity of the light-emitting element is covered with an elastic silicone material and its outer side is covered with an epoxy resin having a large mechanical strength has a problem in that the epoxy resin is degraded over time by the light and heat emitted from the light-emitting element, thus lowering its light transmittance and leading to a lower luminous flux of the LED.

In other words, the LED generates heat when it is used for a long time, and sometimes is heated up to nearly 100°C or more than 100°C in the vicinity of the light-emitting element. Therefore, even in the LED with the double layer structure in which the vicinity of the light-emitting element is covered with an elastic silicone material and its outer side is covered with an epoxy resin having a large mechanical strength, this heat and light degrade the epoxy resin over time, so that the light-transmitting property of the sealing portion lowers. Further, since a light-emitting device using a white LED is provided with a light-emitting element emitting high energy light in the blue and ultraviolet regions, the degradation of the epoxy resin is enhanced further.

Moreover, in the above-described LED with the double layer structure, when the resin in the inner layer expands or shrinks due to the heat generated by the light-emitting element, the resin in the inner layer and the resin in the outer layer are more likely to peel off from each other at an interface between them. Furthermore, a stress is applied to the resin in the outer layer, thus generating cracks or the like, so that the reliability in the sealing portion may be impaired.

In particular, in the above-described surface mount-type LED 30 illustrated in FIG. 12, regardless of whether the sealing portion has a single layer structure or a double layer structure, when the silicone material is used as the sealing resin 33, the adhesiveness to the reflecting plate 34 becomes insufficient. Also, since the silicone material tends to expand and shrink due to heat, the sealing resin 33 and the reflecting plate 34 peel off from each other, and moisture enters through this peeling part, thus affecting the light-emitting element 32 adversely in some cases. Moreover, even when the epoxy resin is used as the sealing resin 33, a use of aluminum, for example, as a material of the reflecting plate 34 lowers the adhesiveness of the sealing resin 33 to the reflecting plate 34, causing a problem similar to the above.

US 4,774,434 shows a LED device sealed with a triple layer and represents the closest prior art.

### Disclosure of Invention

A first light-emitting device includes a light-emitting element, and a light-transmitting sealing portion covering the light-emitting element. The sealing portion includes a first sealing layer covering an outer surface of the light-emitting element, a second sealing layer covering the first sealing layer and a third sealing layer covering the second sealing layer.

The light-emitting device includes a substrate, a light-emitting element mounted on a sub-mount, the sub-mount being disposed on the substrate and connected to it electrically through a wire, a light-transmitting sealing portion covering the light-emitting and elements. The sealing portion includes a first sealing layer covering outer surfaces of the light-emitting elements, a second sealing layer covering the first sealing layer and the wire, and a third sealing layer covering the second sealing layer.

The first sealing layer is formed of a silicone material, and the second and third sealing layers are formed of an epoxy material.

### Brief Description of Drawings

FIG. 1 is a sectional view showing a lamp-type LED as an example of a light-emitting device.
FIG. 2 is a sectional view showing a white LED as another example of the light-emitting device.
FIG. 3 is a sectional view showing another white LED as an example of the light-emitting device according to the present invention.
FIG. 4 is a sectional view showing another white LED as an example of the light-emitting device.
FIG. 5 is a sectional view showing another white LED as an example of the light-emitting device.
FIG. 6 is a sectional view showing another white LED as an example of the light-emitting device.
FIG. 7 is a sectional view showing another white LED as an example of the light-emitting device.
FIG. 8 is a sectional view showing another white LED as an example of the light-emitting device.
FIG. 9 is a sectional view showing an illuminating module using another white LED as an example of the light-emitting device according to the present invention.
FIG. 10 shows a relationship between an elapsed time and a luminous flux maintenance factor in the illuminating module.
FIG. 11 is a sectional view showing a conventional lamp-type LED.
FIG. 12 is a sectional view showing a conventional surface mount-type LED.

### Description of the Invention

An exemplary light-emitting device includes a light-emitting element and a light-transmitting sealing portion covering the light-emitting element. The sealing portion includes a first sealing layer covering an outer surface of the light-emitting element, a second sealing layer covering the first sealing layer and a third sealing layer covering the second sealing layer.

The above-noted sealing portion is formed to have a triple layer structure, thereby increasing the flexibility in selecting a sealing material and a sealing structure for each layer, making it possible to select a sealing material and a sealing structure that are optimum for each layer. Consequently, a decrease in luminous flux of the light-emitting device can be suppressed, and the reliability of the sealing portion can be improved.

More specifically, for example, as the sealing material used for the first sealing layer, it is possible to use a light-transmitting material whose light transmission factor is not lowered very much by light and heat emitted from the light-emitting element and that has an elasticity. The use of the sealing material whose light transmission factor is not lowered very much by the light and heat emitted from the light-emitting element prevents the sealing material of the first sealing layer from degrading over time, thus preventing deterioration in the light-transmitting property. Also, the use of the sealing material that has an elasticity prevents damage due to an application of a mechanical stress to the light-emitting element or cracks generated in the sealing material in the vicinity of the light-emitting element.

The above-noted light-transmitting material whose light transmission factor is not lowered very much by the light and heat and that has an elasticity can be, for example, water glass or a silicone material such as a silicone resin, a silicone rubber, or the like.

Further, as the sealing material used for the second sealing layer, a heat and light resistant light-transmitting material whose light transmission factor is not lowered very much by light and heat emitted from the light-emitting element can be used, for example. This prevents the sealing material of the second sealing layer from degrading over time, thus preventing deterioration in the light-transmitting property. At the same time, a heat-shielding effect of the first sealing layer and the second sealing layer prevents the sealing material of the third sealing layer from degrading over time, thus preventing deterioration in the light-transmitting property.

The above-noted heat and light resistant light-transmitting material whose light transmission factor is not lowered very much by the light and heat can be, for example, a heat and light resistant epoxy material such as a silicone modified epoxy resin, an epoxy resin containing a hydrogenated bisphenol A glycidyl ether as a main component, or a fluorocarbon resin, a fluorocarbon rubber, a silicone material, water glass or the like.

Furthermore, as the sealing material used for the third sealing layer, a light-transmitting material having a rigidity can be used, for example. This makes it possible to protect the light-emitting element from an external shock.

The above-noted light-transmitting material having a rigidity can be an epoxy material such as an epoxy resin, or glass, a nylon resin, polycarbonate, an acrylic resin or the like.

Also, the second sealing layer preferably is formed of a light-transmitting material whose glass transition temperature is equal to or higher than 100°C, more preferably is formed of a light-transmitting material whose glass transition temperature is equal to or higher than 120°C and most preferably is formed of a light-transmitting material whose glass transition temperature is equal to or higher than 140°C. This makes it possible to alleviate the stress from the second sealing layer to the third sealing layer so as to improve the reliability of the sealing portion by the third sealing layer. In other words, by forming the second sealing layer with a light-transmitting material whose glass transition temperature is equal to or higher than 100°C, even when the light-emitting element is kept operating continuously in a state where the operating temperature of the atmosphere varies greatly, the deformation of the second sealing layer caused by the expansion and shrinkage can be suppressed, and the stress from the second sealing layer to the third sealing layer can be alleviated. Although the upper limit of the glass transition temperature is not particularly limited, the glass transition temperature is not higher than 190°C, for example, in the case of an epoxy material used generally for sealing an LED.

The above-noted glass transition temperature of the light-transmitting material of the second sealing layer can be adjusted suitably. For example, the glass transition temperature can be varied by changing the composition of the light-transmitting material, raising the curing temperature of the light-transmitting material, adjusting the amount of a curing agent or the like.

Also, the light-emitting device according to the present embodiment further includes a substrate on which the light-emitting element is mounted, and can include a reflecting member disposed on the substrate. The reflecting member can surround the light-emitting element, the first sealing layer can cover the outer surface of the light-emitting element, the second sealing layer can cover the first sealing layer, and the third sealing layer can cover the second sealing layer and the reflecting member. Further, the third sealing layer can be made to adhere to the substrate. The third sealing layer covers all of the light-emitting element, the first sealing layer, the second sealing layer and the reflecting member on the substrate, and the third sealing layer and the substrate are made to adhere to each other at a peripheral part of these members. This makes it possible to prevent moisture or the like from entering an inside of the light-emitting device more reliably, thus improving the reliability of the sealing portion of the light-emitting device further.

Further, the above-mentioned reflecting member is not particularly limited as long as it has a function of reflecting light from the light-emitting element. For example, a reflecting plate, a reflecting film, a prism or the like can be used.

Moreover, the coefficient of linear expansion of the sealing material forming the first sealing layer and that forming the second sealing layer can be made substantially equal to each other, or the coefficient of linear expansion of the sealing material forming the second sealing layer and that forming the third sealing layer can be made substantially equal to each other. In this way, even when repeating a high temperature state in which the light-emitting element emits light and a low temperature state in which it does not emit light, cracks are not generated easily in each layer of the sealing portion, thus improving the reliability of the sealing portion.

It also is preferable that at least one sealing layer selected from the group consisting of the first sealing layer, the second sealing layer and the third sealing layer contains a phosphor material that is excited by light emitted from the light-emitting element so as to emit light. This allows a wavelength conversion of the light emitted from the light-emitting element so as to emit light at a desired wavelength. Furthermore, in the case where the light-emitting element emits visible light, it is possible to provide a light-emitting device whose output light includes an emission component from the light-emitting element and that from the phosphor material.

Furthermore, it is preferable that the third sealing layer has a higher refractive index than the second sealing layer, and the second sealing layer has a higher refractive index than the first sealing layer. This reduces the total reflection of light, making it possible to raise the light extraction efficiency.

Moreover, the light-emitting device according to the present embodiment can include a plurality of light-emitting elements. This makes it possible to use this light-emitting device as a high-power illuminating module. In this case, the first sealing layer and the second sealing layer may be formed for each light-emitting element and do not have to be layers covering the plurality of light-emitting elements continuously.

Now, instances of light-emitting devices will be described, with reference to the accompanying drawings.

### (First Instance)

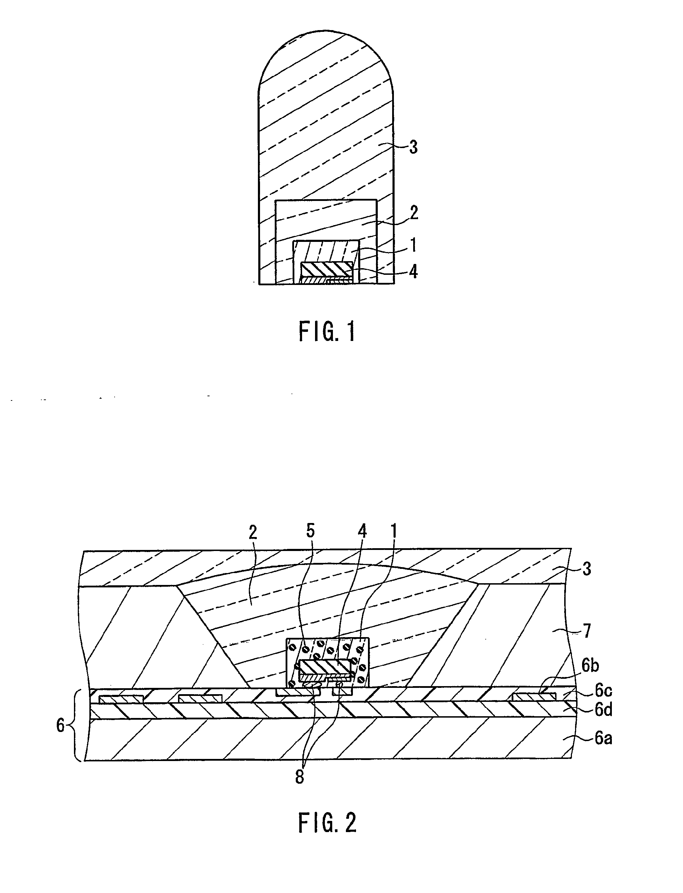

FIG. 1 is a sectional view showing a lamp-type LED as an example of a light-emitting device according to the present invention. In this light-emitting device, an outer surface of a light-emitting element 4 is covered with a first sealing layer 1 formed of a first light-transmitting material. The first sealing layer 1 is covered with a second sealing layer 2 formed of a second light-transmitting material, and the second sealing layer 2 is covered with a third sealing layer 3 formed of a third light-transmitting material. In other words, a sealing portion of this light-emitting device has a triple layer structure including the first sealing layer 1, the second sealing layer 2 and the third sealing layer 3.

The first light-transmitting material can be the above-mentioned light-transmitting material whose light transmission factor is not lowered very much by the light and heat emitted from the light-emitting element 4 and that has an elasticity, and most preferably is a silicone material such as a silicone resin, a silicone rubber, or the like. The second light-transmitting material can be the above-mentioned heat and light resistant light-transmitting material whose light transmission factor is not lowered very much by the light and heat emitted from the light-emitting element 4, and most preferably is a heat and light resistant epoxy material such as a silicone modified epoxy resin, an epoxy resin containing a hydrogenated bisphenol A glycidyl ether as a main component, or the like. In addition, the third light-transmitting material can be the above-mentioned light-transmitting material having a rigidity, and most preferably is an epoxy material such as an epoxy resin or the like.

Furthermore, a phosphor material as a material for converting a wavelength of light emitted from the light-emitting element 4 or a filter material, a pigment or the like for absorbing light at a specific wavelength emitted from the light-emitting element 4 may be contained in at least one selected from the group consisting of the first light-transmitting material, the second light-transmitting material and the third light-transmitting material.

### (Second Instance)

FIG. 2 is a sectional view showing a white LED as another example of a light-emitting device according to the present invention. In this light-emitting device, an outer surface of a light-emitting element 4 is covered with a first sealing layer 1, the first sealing layer 1 is surrounded by and covered with a second sealing layer 2, and the second sealing layer 2 is covered with a third sealing layer 3. In other words, a sealing portion of this light-emitting device has a triple layer structure including the first sealing layer 1, the second sealing layer 2 and the third sealing layer 3. The second sealing layer 2 is formed into a convex lens shape for focusing light.

A first light-transmitting material forming the first sealing layer 1 can be the above-mentioned light-transmitting material whose light transmission factor is not lowered very much by the light and heat emitted from the light-emitting element 4 and that has an elasticity, and most preferably is a silicone material. In order to prevent damages to the light-emitting element 4, the first sealing layer 1 preferably has a thickness of 40 µm to 300 µm from the outer surface of the light-emitting element 4.

A second light-transmitting material forming the second sealing layer 2 can be the above-mentioned heat and light resistant light-transmitting material whose light transmission factor is not lowered very much by the light and heat emitted from the light-emitting element 4, and most preferably is a heat and light resistant epoxy material, although an epoxy material, a silicone material, water glass or the like can be used. In order to block heat emitted from the light-emitting element 4 and not to increase internal stress, the second sealing layer 2 preferably has a thickness of 150 µm to 1000 µm from an interface with the first sealing layer 1.

In addition, a third light-transmitting material forming the third sealing layer 3 can be the above-mentioned light-transmitting material having a rigidity, and most preferably is an epoxy material having an excellent adhesiveness to a reflecting plate 7 and a multilayer substrate 6, which will be described later. In order to protect the light-emitting element 4 from an external shock, the third sealing layer 3 preferably has a thickness of 100 µm to 1000 µm from an interface with the second sealing layer 2.

Further, the first sealing layer 1 contains a phosphor, for example, (Y, Gd)₃Al₅O₁₂: Ce³⁺ or (Sr, Ba)₂SiO₄: Eu²⁺ as a yellow phosphor 5 that is activated with Eu²⁺ ions and has an emission peak in a wavelength region from 560 nm to shorter than 580 nm.

The light-emitting element 4 is a blue light-emitting element having an emission peak in a wavelength region from 440 nm to shorter than 500 nm. The above-noted yellow phosphor 5 is excited by blue light from the light-emitting element 4 so as to emit light including an emission component from the light-emitting element 4 and that from the yellow phosphor 5. Due to the mixture of the blue light and the yellow light, this output light becomes white light.

The light-emitting element 4 is mounted on the multilayer substrate 6 via bumps 8. The multilayer substrate 6 includes a metal plate 6a, a first insulating layer 6c and a second insulating layer 6d. Further, in the first insulating layer 6c, a wiring pattern 6b is formed. Moreover, on the multilayer substrate 6, a parabolic reflecting plate 7 is disposed, and the light-emitting element 4 is disposed inside the parabolic portion of the reflecting plate 7.

The light-emitting device is formed by forming the first light-transmitting material (the first sealing layer 1) containing the yellow phosphor 5 by printing so as to cover the light-emitting element 4, applying the second light-transmitting material (the second sealing layer 2) inside the parabolic portion of the reflecting plate 7 by a dispenser method, followed by heating and curing, and then forming the third light-transmitting material (the third sealing layer 3) having an excellent adhesiveness to the reflecting plate 7 and the multilayer substrate 6 by transfer molding. In addition to the first sealing layer 1 and the second sealing layer 2, the third sealing layer 3 is provided to cover the entire light-emitting device, thereby achieving a better sealing.

In the case of covering the light-emitting element with a single sealing resin and heating and curing the sealing resin to achieve sealing, the difference in temperature between the sealing resin surrounding the light-emitting element and the sealing resin in the vicinity of the outer surface arises at the time of curing the sealing resin, so that a residual stress is generated easily inside the sealing resin. In contrast, by forming the sealing portion with the triple layer structure as in the light-emitting device according to the present embodiment, the heating and curing can be conducted for each layer, and each layer can be made thinner compared with the case of the single layer structure. Consequently, a residual stress is not generated easily.

By changing the height of the convex lens shape of the second sealing layer 2, it is possible to change the luminous intensity distribution of the LED without changing the shapes of the reflecting plate 7 and the third sealing layer 3. In other words, by increasing the height of the convex lens shape, a beam angle can be narrowed.

Further, in the case where an epoxy material is used as the second light-transmitting material forming the second sealing layer 2 and the third light-transmitting material forming the third sealing layer 3, it is preferable that the epoxy material has a glass transition temperature of equal to or higher than 100°C and a coefficient of linear expansion of 5.0 x 10⁻⁵ to 8.0 x 10⁻⁵ in order to prevent cracks being generated in the sealing material due to thermal expansion and shrinkage and maintain a sufficient sealing.

In addition, it is preferable that the refractive index decreases from the third sealing layer 3 in an outermost part via the second sealing layer 2 as an intermediate layer to the first sealing layer 1 covering the light-emitting element in this order. This reduces the total reflection of light, making it possible to raise a light extraction efficiency.

A large number of the white LEDs according to the present instance can be mounted on a planar substrate so as to be used as a high-power illuminating module.

### (Embodiment of the invention)

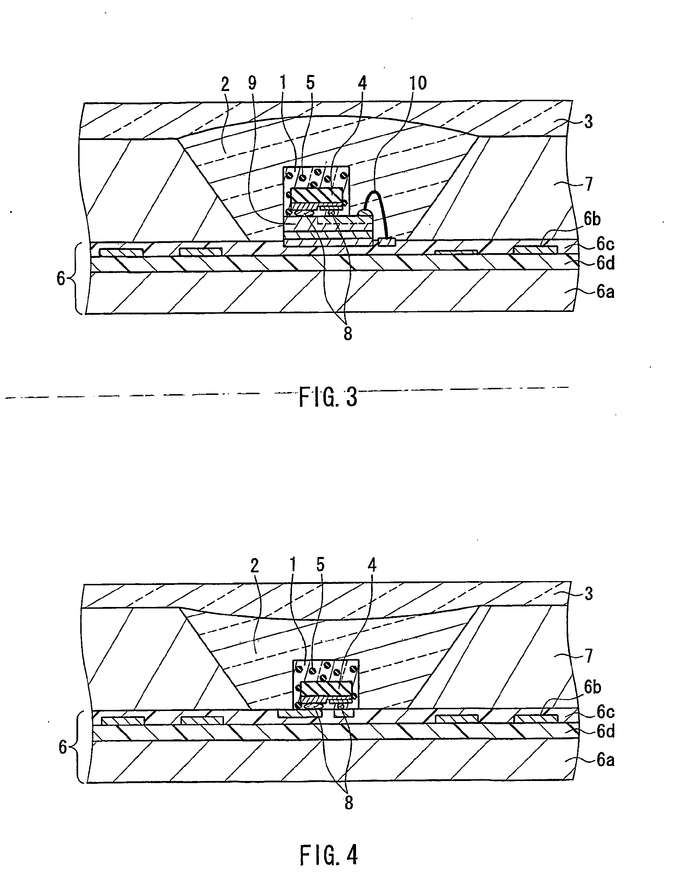

FIG. 3 is a sectional view showing another white LED as an example of the light-emitting device according to the present invention. The light-emitting device in the present embodiment is similar to that in the second instance except that a system of mounting the light-emitting element 4 is changed from a flip-chip type (the second instance) to a silicon sub-mount system. In FIG. 3, numeral 9 denotes a back surface electrode, and numeral 10 denotes a wire. The members common to the second instance are assigned the same reference numerals, and the description thereof will be omitted here.

### (Fourth Instance)

FIG. 4 is a sectional view showing another white LED as an example of the light-emitting device. The light-emitting device in the present instance is similar to that in the second instance except that the shape of the second sealing layer 2 is changed from the convex lens shape to a concave lens shape. In FIG. 4, the members common to the second instance are assigned the same reference numerals, and the description thereof will be omitted here.

### (Fifth Instance)

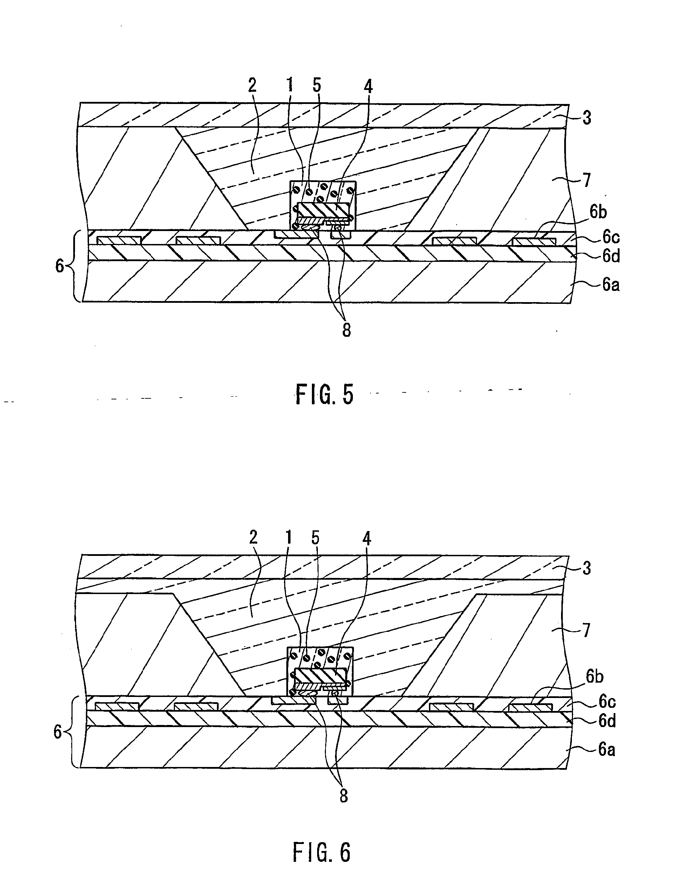

FIG. 5 is a sectional view showing another white LED as an example of the light-emitting device. The light-emitting device in the present instance is similar to that in the second instance except that the shape of the second sealing layer 2 is changed from the convex lens shape to a flat shape. In FIG. 5, the members common to the second instance are assigned the same reference numerals, and the description thereof will be omitted here.

### (Sixth Instance)

FIG. 6 is a sectional view showing another white LED as an example of the light-emitting device. The light-emitting device in the present instance is similar to that in the fifth instance except that the second sealing layer 2 also covers an upper surface of the reflecting plate 7. In FIG. 6, the members common to the fifth instance are assigned the same reference numerals, and the description thereof will be omitted here.

Incidentally, in the case where the second light-transmitting material forming the second sealing layer 2 has a considerably larger coefficient of linear expansion than the third light-transmitting material forming the third sealing layer 3, it is preferable that the second light-transmitting material is filled only within the parabolic portion of the reflecting plate 7 as in the fifth instance in order to alleviate the stress to the third sealing layer 3 caused by thermal shock.

### (Seventh Instance)

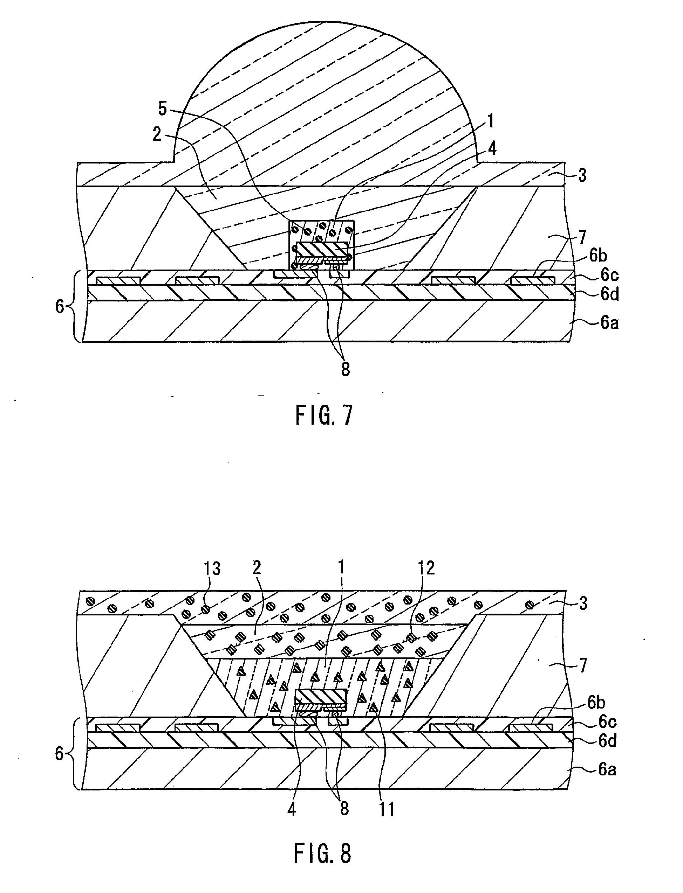

FIG. 7 is a sectional view showing another white LED as an example of the light-emitting device. The light-emitting device in the present instance is similar to that in the fifth instance except that the shape of the third sealing layer 3 is changed from a flat shape to a convex lens shape. In FIG. 7, the members common to the fifth instance are assigned the same reference numerals, and the description thereof will be omitted here.

### (Eighth Instance)

FIG. 8 is a sectional view showing another white LED as an example of the light-emitting device. In the light-emitting device in the present instance, the first sealing layer contains a red phosphor 11, the second sealing layer 2 contains a green phosphor 12, and the third sealing layer 3 contains a blue phosphor 13.

Further, the light-emitting element 4 is an ultraviolet light-emitting element having an emission peak in a wavelength region shorter than 380 nm. The red phosphor 11, the green phosphor 12 and the blue phosphor 13 respectively constituting color elements of Red, Green and Blue (RGB) are excited by ultraviolet light from the light-emitting element 4 so as to emit light. Due to the mixture of the RGB lights emitted from the respective phosphors, the emitted light becomes white light.

The red phosphor 11 can be, for example, Sr₂Si₅N₈: Eu²⁺ or the like, the green phosphor 12 can be, for example, BaMgAl₁₀O₁₇: Eu²⁺, Mn²⁺ or the like, and the blue phosphor 13 can be, for example, BaMgAl₁₀O₁₇: Eu²⁺ or the like.

In the present instance, by changing the concentration of the phosphors contained respectively in the first sealing layer 1, the second sealing layer 2 and the third sealing layer 3 in the sealing portion or changing the thickness of these layers, it is possible to extract light having desired chromaticity coordinates.

If a white resin reflecting plate formed of AMODEL (polyphthalamide), VECTRA (liquid crystal polyester resin) or the like is used as the reflecting plate 7 in the present embodiment, it has a low light reflectance at short wavelengths, and it is degraded by ultraviolet light. Thus, an aluminum reflecting plate or the like having a high reflectance and a stable property toward ultraviolet light or a reflecting plate obtained by depositing metal on a surface of a white resin reflecting plate formed of AMODEL or VECTRA is preferable.

In the present instance, the structure other than that described above is substantially similar to that in the second instance. In FIG. 8, the members common to the second embodiment are assigned the same reference numerals, and the description thereof will be omitted here.

### (Second Embodiment)

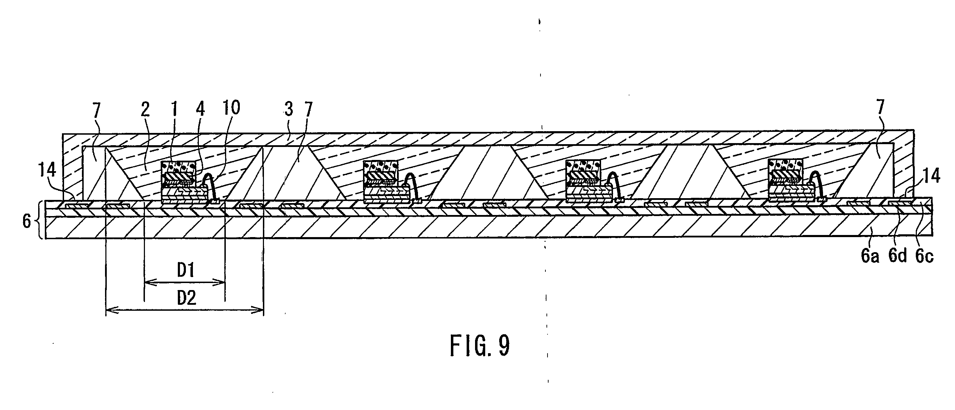

FIG. 9 is a sectional view showing an illuminating module using another white LED as an example of the light-emitting device according to the present invention. The light-emitting device in the present embodiment is a high-power illuminating module obtained by mounting a plurality of the white LEDs according to the third embodiment on a planar substrate. However, in the present embodiment, the second sealing layer 2 is not formed into the convex lens shape. In FIG. 9, the description of the members common to the third embodiment is omitted.

In the present embodiment, the third sealing layer 3 covers all of the light-emitting element 4, the first sealing layer 1, the second sealing layer 2 and the reflecting plate 7 on the multilayer substrate 6, and the third sealing layer 3 and the multilayer substrate 6 are made to adhere to each other at an outermost peripheral part 14 of the reflecting plate 7. In this manner, it is possible to prevent moisture or the like from entering an inside of the light-emitting device reliably, thus improving the reliability of the sealing portion of the light-emitting device.

Hereinafter, the present invention will be described more specifically by way of examples. It should be noted however that the present invention is not limited to these examples below.

### (Example 1)

An illuminating module having a structure similar to that shown in FIG. 9 was produced using 64 white LEDs with a triple layer structure. In other words, the illuminating module in the present example had a structure in which the third sealing layer 3 covered all of the light-emitting element 4, the first sealing layer 1, the second sealing layer 2 and the reflecting plate 7 on the multilayer substrate 6 and the third sealing layer 3 and the multilayer substrate 6 were made to adhere to each other at the outermost peripheral part 14 of the reflecting plate 7.

The first light-transmitting material forming the first sealing layer 1 was a silicone resin ("Silicone AY42" manufactured by Dow Corning Toray Company, Limited), the second light-transmitting material forming the second sealing layer 2 was a modified epoxy resin ("Formulated Epoxy Resin XNR/H5212" manufactured by NAGASE & CO., LTD.; glass transition temperature: 110°C), and the third light-transmitting material forming the third sealing layer 3 was a bisphenol A epoxy resin ("NT300H" manufactured by Nitto Denko Corporation).

With respect to 100 parts by weight first light-transmitting material, 70 parts by weight (Y, Gd)₃Al₅O₁₂: Ce³⁺ yellow phosphor was contained. As the light-emitting element 4, a blue light-emitting element having an emission peak in a wavelength region from 440 nm to shorter than 500 nm was used.

The metal plate 6a was a 1.0 mm thick aluminum plate, and the first insulating layer 6c and the second insulating layer 6d respectively were formed using a 0.1 mm thick epoxy resin containing an inorganic filler such as Al₂O₃ or the like. The reflecting plate 7 was a 0.5 mm thick aluminum plate. Also, the inner diameter D1 of the parabolic portion of the reflecting plate 7 (see FIG. 9) was 1.69 mm, and the outer diameter D2 thereof (see FIG. 9) was 2.34 mm. The first sealing layer 1 had a thickness of 0.1 to 0.2 mm from the outer surface of the light-emitting element 4, and the third sealing layer 3 had a thickness of 0.4 mm on the reflecting plate 7.

### (Example 2)

An illuminating module was produced similarly to Example 1 except that a silicone resin manufactured by GE Toshiba Silicones (glass transition temperature: 60°C) was used as the second light-transmitting material.

### (Comparative Example)

An illuminating module was produced similarly to Example 1 except that the second sealing layer 2 and the third sealing layer 3 were formed together as a single layer using the bisphenol A epoxy resin used in Example 1 and combined with the first sealing layer 1 so as to form a sealing portion with a double layer structure.

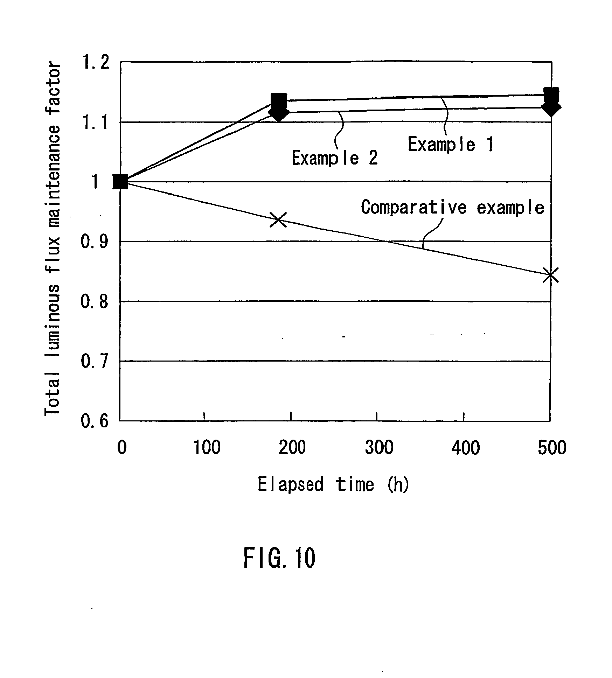

Next, a lifetime test was conducted for the illuminating modules of Example 1, Example 2 and Comparative Example. Under a test condition in which the temperature of the light-emitting element was maintained at 100°C, the relationship between an elapsed time and a total luminous flux maintenance factor was determined. The total luminous flux was measured by an integrating sphere with a diameter of 60 cm. FIG. 10 shows the results. In FIG. 10, the total luminous flux maintenance factor was expressed as a relative value when the total luminous flux at the start of the test was given as 1 (the reference value).

As becomes clear from FIG. 10, for the illuminating modules of Examples 1 and 2, the total luminous flux maintenance factor remained 1 (100%) or higher when 500 hours elapsed. On the other hand, for the illuminating module of Comparative Example, the total luminous flux maintenance factor lowered to 0.85 (85%) when 500 hours elapsed.

### (Example 3)

An illuminating module was produced similarly to Example 1 except that the glass transition temperature of the modified epoxy resin used as the second light-transmitting material in Example 1 was varied.

Next, using the obtained illuminating module, a thermal shock test was conducted in accordance with Japanese Industrial Standards (JIS) C 7021. This thermal shock test evaluates the tolerance of a semiconductor device when the semiconductor device is subjected to repeated thermal distortions, and is carried out in a liquid layer. The temperature of the liquid layer on a high temperature side was set to 100°C, which could be reached in the case where the illuminating module was kept operating continuously, whereas the temperature of the liquid layer on a low temperature side was set to -40°C. The liquid in the liquid layer was a fluoridated chemically inert fluid "Galden" for both of the high temperature side and the low temperature side. The immersion period at each temperature was 5 minutes, the transfer period from the high temperature side to the low temperature side was within 10 seconds, and 100 cycles of these tests were conducted. Further, the illuminating module whose glass transition temperature was 120°C went through the tests up to 200 cycles, and that whose glass transition temperature was 140°C went through the tests up to 300 cycles. Table 1 shows the results.

**(Table 1)**

| Glass transition temperature (°C) | Results of thermal shock test |
|---|---|
| 60 | - Crack generated in third sealing layer |
| | - Crack generated in second sealing layer around wire |
| | - Peeling occurred at interface between third sealing layer and second sealing layer |
| 90 | - Minute crack generated around wire |
| 100 | - No crack or peeling |
| 120 | - No crack or peeling even after 200 test cycles |
| 140 | - No crack or peeling even after 300 test cycles |

As becomes clear from Table 1, by setting the glass transition temperature of the light-transmitting material for the second sealing layer to 100°C or higher, it was possible to maintain the reliability of the sealing portion even in the case where the temperature of an atmosphere in which the light-emitting device was used varied greatly. However, even if the glass transition temperature of the second light-transmitting material was lower than 100°C, no cracks or peeling occurred as long as the illuminating module was kept operating in an atmosphere at room temperature.

The embodiments disclosed in this application are to be considered in all respects as illustrative and not limiting. The scope of the invention is indicated by the appended claims rather than by the foregoing description, and all changes which come within the meaning and range of equivalency of the claims are intended to be embraced therein.

### Industrial Applicability

As described above, by forming a sealing portion of an LED to have a triple layer structure, the present invention makes it possible to select a sealing material and a sealing structure that are optimum for each layer, thereby suppressing a decrease in luminous flux of the light-emitting device and improving the reliability of the sealing portion. Thus, the present invention improves the reliability of the light-emitting device in various displays and luminaires.

## Claims

1. A light-emitting device comprising:
a substrate (6);
a sub-mount substrate (9) disposed on the substrate (6) ;
a light-emitting element (4); and
a light-transmitting sealing portion (1, 2, 3) covering the light-emitting element (4);
wherein
the sealing portion comprises a first sealing layer (1) covering an outer surface of the light-emitting element (4), a second sealing layer (2) covering the first sealing layer (1), and a third sealing (3) layer covering the second sealing layer (2),
**characterized in that**
the light-emitting element is mounted on the sub-mount substrate (9),
the substrate (6) and the sub-mount substrate (9) are conducted electrically through a wire (10),
the second sealing layer covers the wire (10),
the first sealing layer is formed of a silicone material,
and the second sealing layer and the third sealing layer are formed of an epoxy material.

2. The light-emitting device according to claim 1, further comprising
a reflecting member (7) disposed on the substrate (6), wherein
the reflecting member (7) surrounds the light-emitting element (4), and
the third sealing layer (3) covers the reflecting member (7) and is made to adhere to the substrate (6).

3. The light-emitting device according to claim 1, wherein the second sealing layer (2) is formed of a light-transmitting material whose glass transition temperature is equal to or higher than 100°C.

4. The light-emitting device according to claim 1, wherein at least one sealing layer selected from the group consisting of the first sealing layer (1), the second sealing layer (2) and the third sealing layer (3) comprises a phosphor material that is excited by light emitted from the light-emitting element (4) so as to emit light.

5. The light-emitting device according to claim 1, wherein a sealing material forming the second sealing layer (2) has a substantially equal coefficient of linear expansion to a sealing material forming the third sealing layer (3).

6. The light-emitting device according to claim 1, wherein the third sealing layer (3) has a higher refractive index than the second sealing layer (2), and the second sealing layer (2) has a higher refractive index than the first sealing layer (1).

7. The light-emitting device according to claim 1, comprising a plurality of the light-emitting elements (4).

## Patentansprüche

1. Lichtemittierende Vorrichtung, mit:
einem Substrat, (6),
einem Sub-Montage-Substrat (9), das auf dem Substrat (6) angebracht ist,
einem lichtemittierenden Element (4), und
einem lichtdurchlässigen Dichtabschnitt (1, 2, 3), der das lichtemittierende Element (4) bedeckt,
wobei
der Dichtabschnitt eine erste Dichtschicht (1), die eine äußere Oberfläche des lichtemittierenden Elements (4) bedeckt, eine zweite Dichtschicht (2), die die erste Dichtschicht (1) bedeckt, und eine dritte Dichtschicht (3) umfasst, die die zweite Dichtschicht (2) bedeckt,
**gekennzeichnet dadurch, dass**
das lichtemittierende Element auf dem Sub-Montage-Substrat (9) montiert ist,
das Substrat (6) und das Sub-Montage-Substrat (9) miteinander elektrisch durch einen Draht (10) verbunden sind,
die zweite Dichtschicht den Draht (10) bedeckt,
die erste Dichtschicht aus einem Siliziummaterial gebildet ist, und
die zweite Dichtschicht und die dritte Dichtschicht aus einem Epoxy-Material gebildet sind.

2. Lichtemittierende Vorrichtung nach Anspruch 1, ferner mit:
einem Reflektionselement (7), das auf dem Substrat (6) angeordnet ist, wobei das Reflektionselement (7) das lichtemittierende Element (4) umgibt, und
die dritte Dichtschicht (3) das reflektierende Element (7) bedeckt und so hergestellt ist, dass sie am Substrat (6) anhaftet.

3. Lichtemittierende Vorrichtung nach Anspruch 1,
wobei die zweite Dichtschicht (2) aus einem lichtdurchlässigen Material gebildet ist, dessen Glasübergangstemperatur gleich oder höher als 100° C ist,

4. Lichtemittierende Vorrichtung nach Anspruch 1,
wobei wenigstens eine Dichtschicht ausgewählt aus der Gruppe bestehend aus der ersten Dichtschicht (1), der zweiten Dichtschicht (2) und der dritten Dichtschicht (3) ein Phosphormaterial umfasst, das durch Licht, das von der lichtemittierenden Vorrichtung (4) emittiert wird, angeregt wird, um so Licht zu emittieren.

5. Lichtemittierende Vorrichtung nach Anspruch 1,
wobei ein Dichtmaterial, das die zweite Dichtschicht (2) bildet, einen linearen Expansionskoeffizienten aufweist, der im Wesentlichen gleich zu dem eines Dichtmaterials ist, das die dritte Dichtschicht (3) bildet.

6. Lichtemittierende Vorrichtung nach Anspruch 1,
wobei die dritte Dichtschicht (3) einen höheren Brechungsindex als die zweite Dichtschicht (2) aufweist und die zweite Dichtschicht (2) einen höheren Brechungsindex als die erste Dichtschicht (1) aufweist.

7. Lichtemittierende Vorrichtung nach Anspruch 1,
mit mehreren lichtemittierenden Elementen (4).

## Revendications

1. Dispositif électroluminescent comprenant :
un substrat (6) ;
un substrat d'embase (9) disposé sur le substrat (6) ;
un élément électroluminescent (4) ; et
une partie de scellement (1, 2, 3) transmettant la lumière couvrant l'élément électroluminescent (4) ;
dans lequel
la partie de scellement comprend une première couche de scellement (1) couvrant une surface externe de l'élément électroluminescent (4), une deuxième couche de scellement (2) couvrant la première couche de scellement (1), et une troisième couche de scellement (3) couvrant la deuxième couche de scellement (2),
**caractérisé en ce que**
l'élément électroluminescent est monté sur le substrat d'embase (9),
le substrat (6) et le substrat d'embase (9) sont reliés électriquement à travers un fil (10),
la deuxième couche de scellement couvre le fil (10),
la première couche de scellement est formée d'un matériau en silicone,
et la deuxième couche de scellement et la troisième couche de scellement sont formées d'un matériau époxy.

2. Dispositif électroluminescent selon la revendication 1, comprenant en outre
un élément réfléchissant (7) disposé sur le substrat (6), dans lequel
l'élément réfléchissant (7) entoure l'élément électroluminescent (4), et
la troisième couche de scellement (3) couvre l'élément réfléchissant (7) et est réalisée pour adhérer au substrat (6).

3. Dispositif électroluminescent selon la revendication 1, dans lequel la deuxième couche de scellement (2) est formée d'un matériau transmettant la lumière dont la température de transition vitreuse est supérieure ou égale à 100°C.

4. Dispositif électroluminescent selon la revendication 1, dans lequel au moins une couche de scellement choisie dans le groupe constitué de la première couche de scellement (1), la deuxième couche de scellement (2) et de la troisième couche de scellement (3) comprend un matériau luminophore qui est excité par une lumière émise à partir de l'élément électroluminescent (4) afin d'émettre de la lumière.

5. Dispositif électroluminescent selon la revendication 1, dans lequel un matériau de scellement formant la deuxième couche de scellement (2) a un coefficient de dilatation linéaire essentiellement égal à celui d'un matériau de scellement formant la troisième couche de scellement (3).

6. Dispositif électroluminescent selon la revendication 1, dans lequel la troisième couche de scellement (3) a un indice de réfraction supérieur à celui de la deuxième couche de scellement (2), et la deuxième couche de scellement (2) a un indice de réfraction supérieur à celui de la première couche de scellement (1).

7. Dispositif électroluminescent selon la revendication 1, comprenant une pluralité d'éléments électroluminescents (4).
